# EUROPÄISCHE PATENTANMELDUNG

(11) **EP 0 980 171 A2**
(43) Veröffentlichungstag der Anmeldung: **16.02.2000**
(21) Anmeldenummer: 99113877.7
(22) Anmeldetag: 16.07.1999
(51) Int. Cl.: H04M 1/02

(54) **Moduleinheit für eine Türanlage, insbesondere Türsprechanlage**

(30) Priorität: 12.08.1998 DE 19836459
(71) Anmelder: Ritto - Werk Loh GmbH & Co. KG, 35708 Haiger (DE)
(72) Erfinder: Achenbach, Heinz, 35236 Breidenbach (DE)
(74) Vertreter: Fleck, Hermann-Josef, Dr.-Ing.

(57) **Zusammenfassung**

Die Erfindung betrifft eine Moduleinheit für eine Türanlage, insbesondere Türsprechanlage, die in ein Aufnahmegehäuse zeilen- und/oder spaltenweise aneinanderreihbar einsetzbar ist und in ihrer Frontplatte Funktions-, Bedienungs- und/oder Anzeigeelemente trägt. Das Aussehen und die Anpassung der Moduleinheit an vorgegebene Einbauwünsche werden dadurch verbessert, daß die Frontseite der Moduleinheit mittels einer Dekorplatte abgedeckt ist, die in ihrer Ausgestaltung an die Anordnung und Art der Funktions-, Bedienungs- und/oder Anzeigeelemente angepaßt ist.

## Beschreibung

Die Erfindung betrifft eine Moduleinheit für eine Türanlage, insbesondere Türsprechanlage, die in ein Aufnahmegehäuse zeilen- und/oder spaltenweise aneinanderreihbar einsetzbar ist und in ihrer Frontplatte Funktions-, Bedienungs- und/oder Anzeigeelemente trägt.

Es sind verschieden ausgestattete Moduleinheiten erforderlich, um eine Türanlage, insbesondere Türsprechanlage, zu erstellen. Es ist nur auf ein Kameramodul, ein Türsprechmodul, ein Klingeltastenmodul, ein Bewegungsmeldermodul, ein Lichtmodul, ein Nummernmodul und ein Abdeckmodul verwiesen. Dabei sind unterschiedliche Modulgehäuse nötig, die sich insbesondere in der Ausgestaltung der Frontplatte unterscheiden, in die die unterschiedlichsten Funktions-, Bedienungs- und/oder Anzeigeelemente eingebaut sind. In der Regel besteht das Modulgehäuse aus Kunststoff und ist so ausgestaltet, daß es zusätzliche Halte- und Befestigungsfunktionen übernimmt. Dies führt dazu, daß insbesondere nach einer zusätzlichen Oberflächenbehandlung der Frontplatte der Moduleinheit, bedingt durch Einfallstellen des Kunststoffteils, Schlieren und Unregelmäßigkeiten der Oberfläche hervortreten, die das Aussehen der Türanlage nachteilig beeinträchtigen.

Es ist Aufgabe der Erfindung, eine Moduleinheit der eingangs erwähnten Art zu schaffen, die ohne Beeinträchtigung der zugeordneten Funktion das frontseitige Aussehen derselben verbessert und dennoch leicht im Aussehen verändert und angepaßt werden kann.

Diese Aufgabe wird nach der Erfindung dadurch gelöst, daß die Frontseite der Moduleinheit mittels einer Dekorplatte abgedeckt ist, die in ihrer Ausgestaltung an die Anordnung und Art der Funktions-, Bedienungs- und/oder Anzeigeelemente angepaßt ist.

Mit den zusätzlichen Dekorplatten kann das Aussehen der Moduleinheit nicht nur verbessert werden, da diese ohne Oberflächenfehler hergestellt, an die Funktions-, Bedienungs- und/oder Anzeigeelemente der Moduleinheit optimal angepaßt und leicht ausgetauscht werden können, so daß schließlich das Aussehen der Moduleinheit leicht verändert und an vorliegende Gegebenheiten angepaßt werden kann.

Nach einer Ausgestaltung kann dazu vorgesehen sein, daß die Dekorplatte auf die Frontseite aufgelegt und mit der Moduleinheit im Aufnahmegehäuse gehalten ist. Der Austausch der Dekorplatte ist dann leicht vorzunehmen. Die Ausgestaltung kann jedoch auch so ausgeführt sein, daß die Dekorplatte mit der Frontseite der Moduleinheit fest oder lösbar verbunden oder verbindbar ist.

Eine Ausgestaltung für eine lösbare Anbringung der Dekorplatte an der Moduleinheit ist dadurch gekennzeichnet, daß das Gehäuse der Moduleinheit an seinen Außenseiten eine umlaufende Haltenut aufweist, die zur Frontseite hin eine Halteplatte abteilt, und daß die Dekorplatte an zwei einander gegenüberliegenden Seiten einen L-förmigen Haltesteg trägt, der in die Haltenut der Moduleinheit einführbar ist und die Halteplatte aufnimmt.

Die Anzahl der Dekorplatten pro Türanlage läßt sich dadurch reduzieren, daß die Dekorplatte mehrere, in Zeilen und/oder Spalten angeordnete Moduleinheiten abdeckt.

Ist nach einer weiteren Ausgestaltung vorgesehen, daß die Dekorplatte aus Metall, vorzugsweise Edelmetall, oder aus mit veredeltem Überzug versehenen Metall besteht, dann kann die Frontseite der Moduleinheit nicht verkratzt oder leicht beschädigt werden und ein edles Aussehen der Türanlage erreicht werden.

Aus Kostengründen kann das Modulgehäuse aus Kunststoff bestehen.

Die Erfindung wird anhand in den Zeichnungen dargestellten Ausführungsbeispielen näher erläutert. Es zeigen:
- Fig. 1: in perspektivischer Ansicht eine als Türsprech-Modul ausgebildete Moduleinheit,
- Fig. 2: eine der Fig. 1 entsprechende Moduleinheit mit lösbarer Anbringung der Dekorplatte an der Moduleinheit und
- Fig. 3: eine Ansicht auf eine Außenseite der Moduleinheit bei abgenommener Moduleinheit.

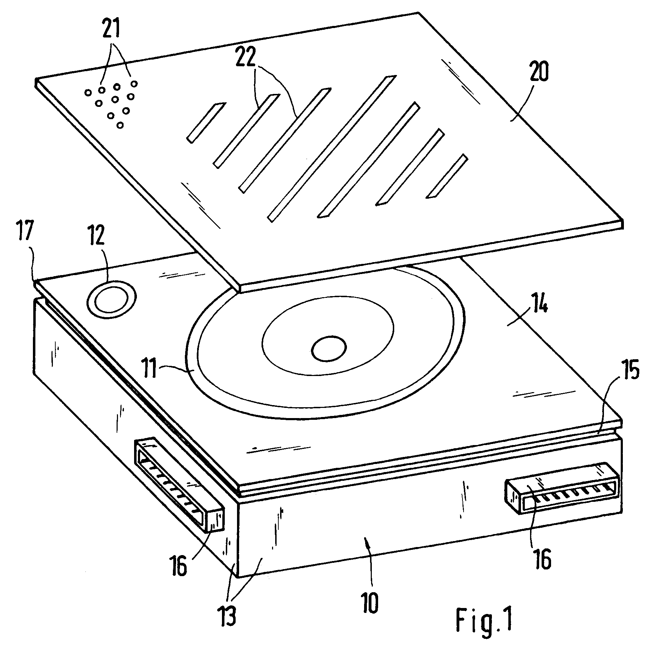

In Fig. 1 ist eine Moduleinheit 10 dargestellt, die als Türsprechmodul ausgelegt ist. Im Modulgehäuse ist ein Lautsprecher 11 und ein Mikrophon 12 eingebaut, sowie die dazugehörigen Verstärker. Die Schalleintritts- und Schallaustrittsöffnung befinden sich in der Frontseite 14 der Moduleinheit 10. Der elektrische Anschluß des Türsprechmoduls erfolgt über Steckerleisten 16, die in Außenseiten 13 der Moduleinheit 10 eingebaut sind. Die Moduleinheit 10 ist in den Außenseiten 13 mit einer umlaufenden Haltenut 15 versehen, die zur Frontseite 14 hin eine Halteplatte 17 abteilt. Die Frontseite 14 der Moduleinheit 10 wird mittels einer Dekorplatte 20 abgedeckt, die entsprechend der Anordnung des Lautsprechers 11 und des Mikrophons 12 in der Frontseite 14 der Moduleinheit 10 mit Schalleintrittsöffnungen 21 und Schallaustrittsöffnungen 22 versehen ist. Die Dekorplatte 20 hat dieselbe Größe wie die Halteplatte 17 der Moduleinheit 10 und kann zusammen mit dieser von einer Aufnahmenut des Aufnahmegehäuses aufgenommen und gehalten werden.

Die Dekorplatte 20 kann in der Ausgestaltung an die Frontseite 14 der Moduleinheit 10 mit unterschiedlichen Funktions-, Bedienungs- und/oder Anzeigeelemente leicht angepaßt werden. Auch in der Materialwahl und Oberfläche bietet die von der Moduleinheit 10 getrennte Dekorplatte 20 vielfache Gestaltungsmöglichkeiten. Besteht das Modulgehäuse 10 vorzugsweise aus Kunststoff, so kann für die Dekorplatte 20 Metall, wie Edelmetall, oder mit veredeltem Überzug versehenes Metall verwendet werden. Dabei spielen Aussehen, Stabilität, insbesondere Kratzfestigkeit, eine wesentliche Rolle.

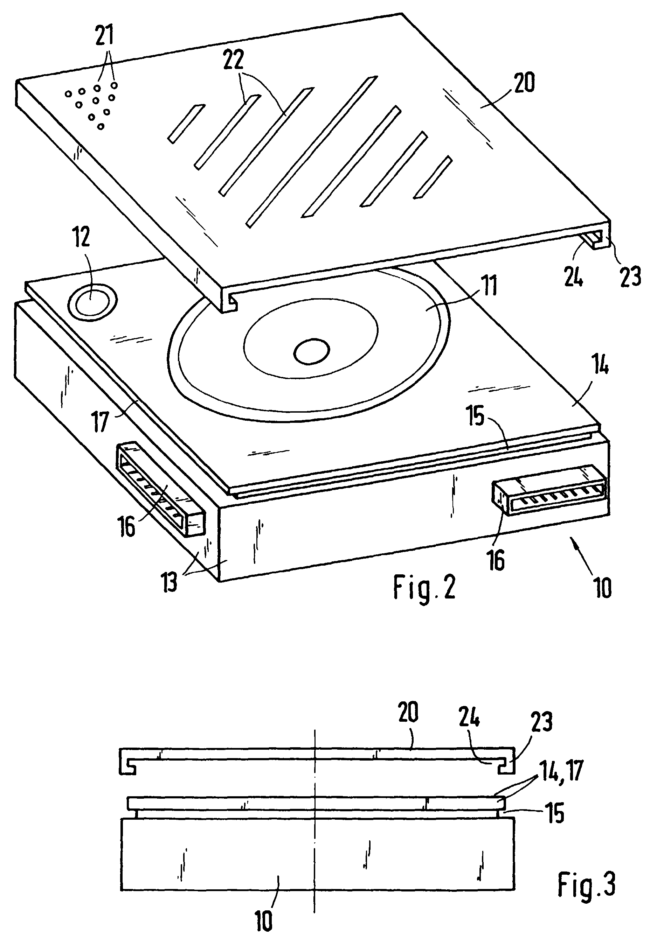

Wie die Fig. 2 und 3 zeigen, kann die Dekorplatte 20 auch lösbar mit der Moduleinheit 10 verbunden werden, sodaß sie mit der Moduleinheit 10 eine in das Aufnahmegehäuse einsetzbare Einheit bildet. Die Dekorplatte 20 trägt an zwei einander gegenüberliegenden Seiten L-förmige Haltestege 23 mit einer Haltenut 24, so daß sie auf die Frontplatte 17 der Moduleinheit 10 aufgeschoben werden kann. Die Frontplatte 17 der Moduleinheit 10 ist dabei gegenüber den Außenseiten 13 der Moduleinheit 10 zumindest an zwei einander gegenüberliegenden Seiten zurückgesetzt, so daß die aufgeschobene Dekorplatte 20 mit den Außenseiten 13 der Moduleinheit 10 bündig abschließt. Auf diese Weise läßt sich auch sicherstellen, daß die Dekorplatte 20 in der richtigen Ausrichtung auf die Frontplatte 17 der Moduleinheit 10 aufgeschoben wird.

Die Dekorplatte 20 kann auch mittels anders gestalteter Befestigungselemente fest oder lösbar mit der Moduleinheit 10 verbunden werden, ohne auf die Vorteile der von der Moduleinheit 10 getrennt hergestellten Dekorplatte 20 verzichten zu müssen.

## Patentansprüche

1. Moduleinheit für eine Türanlage, insbesondere Türsprechanlage, die in ein Aufnahmegehäuse zeilen- und/oder spaltenweise aneinanderreihbar einsetzbar ist und in ihrer Frontplatte Funktions-, Bedienungs- und/oder Anzeigeelemente trägt,
dadurch gekennzeichnet,
daß die Frontseite (14) der Moduleinheit (10) mittels einer Dekorplatte (20) abgedeckt ist, die in ihrer Ausgestaltung an die Anordnung und Art der Funktions-, Bedienungs- und/oder Anzeigeelemente (11, 12) angepaßt ist.

2. Moduleinheit nach Anspruch 1,
dadurch gekennzeichnet,
daß die Dekorplatte (20) auf die Frontseite (14) aufgelegt und mit der Moduleinheit (10) im Aufnahmegehäuse gehalten ist.

3. Moduleinheit nach Anspruch 1,
dadurch gekennzeichnet,
daß die Dekorplatte (20) mit der Frontseite (14) der Moduleinheit (10) fest oder lösbar verbunden oder verbindbar ist.

4. Moduleinheit nach Anspruch 3,
dadurch gekennzeichnet,
daß das Gehäuse der Moduleinheit (10) an seinen Außenseiten (13) eine umlaufende Haltenut (15) aufweist, die zur Frontseite (14) hin eine Halteplatte (17) abteilt, und
daß die Dekorplatte (20) an zwei einander gegenüberliegenden Seiten einen L-förmigen Haltesteg (23) trägt, der in die Haltenut (15) der Moduleinheit (10) einführbar ist und die Halteplatte (17) aufnimmt.

5. Moduleinheit nach einem der Ansprüche 1 bis 4,
dadurch gekennzeichnet,
daß die Dekorplatte (20) mehrere, in Zeilen und/oder Spalten angeordnete Moduleinheiten (10) abdeckt.

6. Moduleinheit nach einem der Ansprüche 1 bis 5,
dadurch gekennzeichnet,
daß die Dekorplatte (20) aus Metall, vorzugsweise Edelmetall, oder aus mit veredeltem Überzug versehenen Metall besteht.

7. Moduleinheit nach einem der Ansprüche 1 bis 6,
dadurch gekennzeichnet,
daß das Modulgehäuse aus Kunststoff besteht.
